(19) Europäisches Patentamt / European Patent Office / Office européen des brevets

(11) **EP 3 301 814 A1**

(12) **EUROPEAN PATENT APPLICATION**

(43) Date of publication:
04.04.2018 Bulletin 2018/14

(51) Int Cl.:
**H03M 13/11** (2006.01)   **H03M 13/23** (2006.01)
**H03M 13/29** (2006.01)

(21) Application number: 16191471.8

(22) Date of filing: 29.09.2016

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Intel IP Corporation**
**Santa Clara, CA 95054 (US)**

(72) Inventors:
• **HUANG, Sheng**
**9220 Norresundby 81 (DK)**
• **BALERCIA, Tommaso**
**9000 Aalborg 81 (DK)**

(74) Representative: **Patentanwälte Lambsdorff & Lange**
**Dingolfinger Strasse 6**
**81673 München (DE)**

(54) **MESSAGE PASSING DECODER FOR DECODING LDPC CODES JOINTLY WITH CONVOLUTIONAL OR TURBO CODES**

(57)    A method of decoding first data encoded by an LDPC code and second data encoded by a convolutional code or a turbo code is described. The method includes decoding first data by an LDPC decoder operating on a LDPC parity-check matrix. The method further includes decoding second data by the LDPC decoder operating on a sparse parity-check matrix defined by the convolutional code or the turbo code, respectively. The same decoder hardware may be used for decoding LDPC codes and convolutional codes or turbo codes. In all these cases decoding may be performed by using a message passing algorithm. When switching from one channel code to the other channel code (e.g. from an LDPC code to a convolutional code or a turbo code), the message passing algorithm is simply adapted by reprogramming the decoder to operate according to the Tanner graph representing the (sparse) parity-matrix of the newly elected code.

Fig. 7

EP 3 301 814 A1

**Description**

FIELD

The disclosure generally relates to a communication system using channel coding and decoding techniques, a channel decoder and a method of channel decoding.

BACKGROUND

In communication systems, interference typically reduces the SINR (Signal to Interference plus Noise Ratio) on transmitted data. Coding and decoding of data by parity-check codes and/or block codes are techniques frequently used to ensure reliability of data transmission. By coding, data is pre-processed in such a way as to allow for reliable data recovery by decoding. Decoding is the process of reconstructing transmitted data which has been coded and transmitted through unreliable media into codewords. Many different coding/decoding schemes are available depending on system and transmission channel considerations. Among many others, low density parity-check (LDPC) codes, convolutional codes (CC) and turbo codes (TC) are frequently used for wireless communication.

BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

Figure 1A is a system diagram showing a transmitter and a receiver of a communications system.

Figure 1B is a schematic representation of a communications system including a transmitter and a receiver.

Figure 2A is a factor graph representation of a linear block code.

Figure 2B shows an example of a parity-check matrix H and a factor graph representation of the parity-check matrix H.

Figure 2C is a part of a factor graph illustrating a message passing algorithm for LDPC decoding.

Figure 3 is a schematic diagram showing an example of a turbo encoder.

Figure 4 is a representation of a sparse lower triangular matrix forming a part of a parity check matrix H of a convolutional code or a turbo code.

Figure 5 is a schematic diagram showing an example of an LDPC decoder for decoding data encoded by an LDPC code and/or data encoded by a convolutional code or a turbo code.

Figure 6 is a schematic diagram showing an example of an LDPC decoder architecture for LDPC decoding according to the message passing algorithm.

Figure 7 illustrates a process flow diagram for decoding first data encoded by an LDPC code and second data encoded by a convolutional code or a turbo code.

Figure 8 is a graph in which the bit error rate (BER) of a decoder output is plotted versus the signal-to-noise ratio (SNR) for comparison of a BCJR, Viterbi and message passing (MP) decoding algorithm for different block sizes.

Figure 9 is a graph in which the bit error rate (BER) of a decoder output is plotted versus the signal-to-noise ratio (SNR) for comparison of a turbo code decoded by a turbo decoder and an LDPC decoder using a message passing (MP) algorithm for different block sizes.

DESCRIPTION OF THE INVENTION

In the following description and claims, the terms "coupled" and "connected", along with derivatives may be used. It should be understood that these terms may indicate that two elements co-operate or interact with each other regardless whether they are in direct physical or electrical contact or they are not in direct contact with each other. Further, although binary data symbols (i.e. bits) and binary codes are used for the purpose of explanation throughout the following description, higher order data symbols and non-binary codes may equally be applied.

The methods, systems and devices described herein may apply channel coding and/or channel decoding. It is understood that comments made in connection with a described method may also hold true for a corresponding device configured to perform the method and vice versa. For example, if a specific method step is described, a corresponding device may include a unit to perform the described method step, even if such a unit is not explicitly described or illustrated in the figures. Further, it is understood that the features of the various exemplary aspects described herein may be combined with each other, unless specifically noted otherwise.

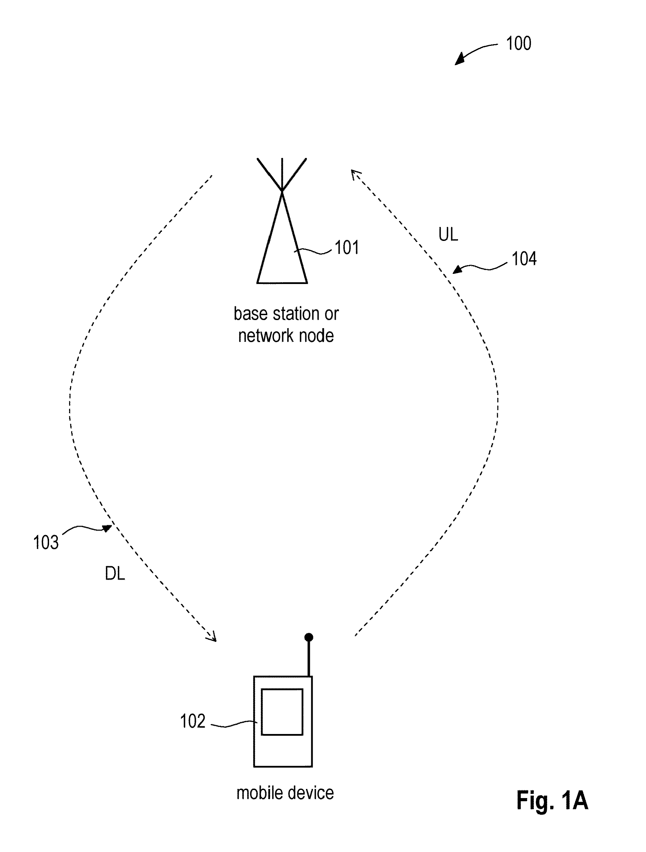

Figure 1A is a system diagram of a communications system 100 including a base station and/or network node 101 and a mobile device (UE) 102. Data generated at the base station and/or network node 101 is channel encoded and transmitted on the downlink (DL) 103 to the mobile device 102. Processing of received data at the mobile device 102 includes channel decoding. Data generated at the mobile device 102 is channel encoded and transmitted on the uplink (UL) 104 to the base station and/or network node. Processing of received data at the base station or network node 101 includes channel decoding.

Examples for such communications system 100 are digital video broadcasting-satellite (DVB-S) systems such as, e.g., the DVB-S2 system, wireless local area network (WLAN) systems such as, e.g., WLAN802.11n or wireless metropolitan area network (WMAN) systems such as, e.g., stipulated in IEEE 802.16. The communications system 100 may be a radio communication system according to the Long Term Evolution (LTE) standard or the advanced version LTE-A thereof, marketed as 4th Generation (4G) or 5th Generation (5G) radio communications system 100. LTE is a standard for wireless communication of high-speed data for mobile devices (e.g. mobile phones) and data terminals. The devices and methods according to this disclosure can also be employed in all systems using LDPC codes (alone or together with other codes such as convolutional codes or turbo codes), such as for example IEEE 802.11n WiFi, IEEE 802.11ac WiFi, IEEE 802.16e WiMax, GMR-1, IEEE 802.3an, IEEE 802.22, CMMB, WiMedia 1.5, DVB-S2, Digital Terrestrial Multimedia Broadcast (DTMB), etc. Moreover, embodiments disclosed herein may include communications systems in which the channel 150 is established by a wired electrical or an optical link.

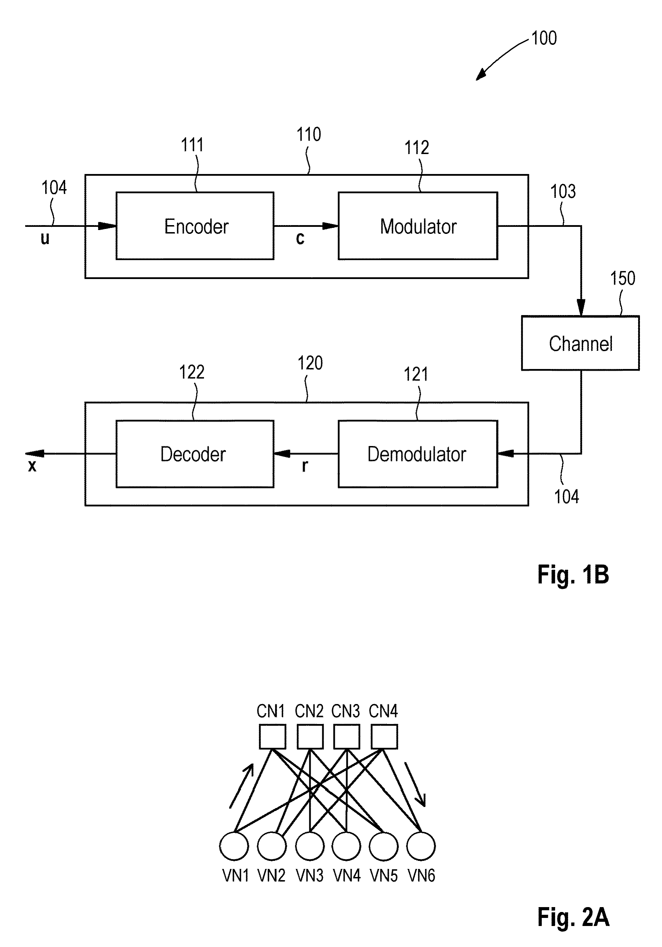

Figure 1B shows an embodiment of the communications system 100 including a transmitter 110 and a receiver 120. The transmitter 110 and/or the receiver 120 may be implemented in network nodes and/or base stations 101 and/or mobile devices 102, also referred to as user equipment (UE), of the communications system 100. For example, the transmitter 110 may be implemented in a network node or base station 101 of the communications system 100, while the receiver 120 may be implemented in a mobile device (UE) 102 of communications system 100. For example, the transmitter 110 may be implemented in a mobile device (UE) 102 of communications system 100, while the receiver 120 may be implemented in a network node or base station 101 of the communications system 100.

The transmitter 110 includes an encoder 111 and may include further data processing units such as a modulator 112, a puncturing device (not shown) etc. The receiver 120 may include a demodulator 121, further data processing units such as, e.g., a de-puncturing device (not shown) and a decoder 122. An output signal 103 of the transmitter 110 is transmitted via a channel 150 to form an input signal 105 of the receiver 120.

It is to be noted that Figure 1B provides a schematic and strongly simplified representation of the transmitter 110 and the receiver 120 of the communications system 100. Usually, the transmitter 110 and the receiver 120 are equipped with additional data processing units (not shown) which are typically adapted to the specific field of application, the type of the channel 150 and other considerations, requirements or constraints. More specifically, the data communications system 100 may be a radio communications system, in particular a mobile radio communications system, in which the channel 150 is represented by a radio link.

In Figure 1B, data symbols $\mathbf{u} = (u_1,...,u_k)$ to be transmitted to the receiver 120 are fed at input 104 into the encoder 111 of the transmitter 110. For ease of notation, data symbols are written as binary data, i.e. a binary row vector of length k (also referred to as a dataword in the following). The encoder 111 provides for a forward error correction (FEC) in the communications system 100. The encoder 111 may use a linear block code for encoding the data bits $u_i$, i = 1,...,k, wherein i is the discrete time index of bits $u_i$. For instance, BCH (Bose-Chaudhuri-Hocquenghem) codes, convolutional codes, turbo codes or LDPC (Low Density Parity-Check) codes may be used. LDPC codes are also known as Gallager codes and are proposed for many future communications systems for FEC as an alternative or complement to turbo codes.

Any linear block code can be described by a parity-check matrix **H.** The parity-check matrix **H** is of format r x n, i.e. has r rows and n columns. All codewords $\mathbf{c} = (c_1,...,c_n)$ must fulfill the equation

$$\mathbf{Hc}^{\mathrm{T}} = 0. \tag{1}$$

Thus, **c** is a codeword of the linear block code represented by the parity-check matrix **H** if and only if equation (1) is valid. Superscript T refers to the transpose of the indexed quantity.

Codeword generation out of the dataword **u** may be written as

$$\mathbf{c} = \mathbf{uG}. \qquad (2)$$

**G** is a generator matrix of the linear block code and is of k x n format, with k = n-r (with k, n, r being integers). As known in the art, one or more generator matrices **G** may be computed from parity-check matrix **H.** If binary data are used (i.e. symbols are represented by bits), operations in equations (1) and (2) are carried out in the binary field GF(2). A convolutional (n,k) code is a convolutional code having a dataword length k and a codeword length n.

The codeword **c** is fed into the modulator 112. Different modulation and/or puncturing schemes may be applied therein. After modulation, optional puncturing and adding of supplementary data, the codeword **c** is sent out by the transmitter 110 to the channel 150.

The output of the modulator 112 may be subjected to further data processing in order to prepare the signal for channel transmission. Such further data processing is not depicted in Figure 1B. By way of example, further data processing may include digital-to-analog conversion, up-conversion of the signal to a radio frequency band, amplification and radiating the amplified signal via a transmit antenna (not shown).

At the receiver 120, an input signal 105 is obtained by, e.g., a receive antenna (not shown) and may be subjected to signal processing not depicted in Figure 1B, such as, e.g., filtering, down-conversion to an intermediate frequency (IF) band or baseband, analog-to-digital conversion and so on. The demodulator 121 may demodulate and optionally de-puncture the received signal 105 and outputs a received vector **r.** The n elements $r_i$, i = 1,...,n of the received vector **r** may be real-valued.

The decoder 122 decodes the received vector **r** to yield the decoded word **x**. The n elements $x_i$, i = 1,...,n of the decoded word **x** are estimates of the n elements $c_i$, i = 1,...,n of codeword **c**.

The encoder 111 may be an LDPC encoder using an LDPC code generator matrix **G**. An LDPC code is a linear code having a sparse parity-check matrix **H,** namely the majority of the entries in the parity-check matrix **H** of an LDPC code are 0's.

The encoder 111 may also be a convolutional encoder or a turbo encoder. For turbo codes or its convolutional code components, the encoding process can be described by equation (2) with the generator matrix **G** be written as

$$\mathbf{G} = [\mathbf{I} \ \mathbf{P}]. \qquad (3)$$

Here, **I** is the identity matrix of k × k format, and **P** is some matrix of k × (n-k) format. For example, for turbo codes, n = 3k. For its convolutional code components, n = 2k. A turbo (n,k) code is a turbo code having a convolutional code component of dataword length k and codeword length n. In general, **P** (of a turbo code or a convolutional code) is not a sparse matrix.

By definition,

$$\mathbf{H} = [\mathbf{P}^\mathbf{T} \ \mathbf{I}] \qquad (4)$$

is a parity-check matrix of the turbo code above or its convolutional code components. Here, **I** is the identity matrix of (n-k) × (n-k) format. However, this is only one parity-check matrix corresponding to the turbo code or its convolutional code components. Specifically, it is a parity-check matrix where neither **P** nor **H** is sparse.

If an LDPC decoder built on this (non-sparse) parity-check matrix would be used for decoding the convolutional code or turbo code, the performance would be poor (namely, the rate of decoding errors would be high). Efficient decoders for decoding turbo codes are known in the art to be iterative decoders using an "upper" SISO (soft-input soft-output) processor, a "lower" SISO processor and an interleaver, wherein $\alpha$-posteriori probabilities are computed by the SISO processors by performing forward and reverse trellis transversals.

The parity-check matrix **H** can also be represented graphically as a factor graph, a so-called Tanner graph. Figure 2A illustrates a Tanner graph. A Tanner graph is a bipartite graph. The nodes of a Tanner graph can be divided into two classes. One class is termed check nodes (CN-nodes CN1, CN2, CN3, CN4 - drawn as squares) and the other class is termed variable or bit nodes (VN-nodes VN1, VN2, VN3, VN4, VN5, VN6 - drawn as circles).

The check nodes correspond to the rows of the parity-check matrix **H** (e.g. VC1 corresponds to row 1 of **H**) and the variable nodes correspond to the columns of the parity-check matrix **H** (e.g. VN1 corresponds to column 1).

That is, a bit i from the channel 150 is represented by a variable node VNi (there are therefore as many variable nodes as bits in the codeword to be decoded) and each parity check j is represented by check node CNj (there are therefore as many check nodes as rows in the parity matrix **H**). A connection (edge) between a variable node VNi and a check node CNj exists if $H_{j,i}$ = 1. As will be explained in more detail below, extrinsic information is exchanged along the edges in both directions (indicated by arrows).

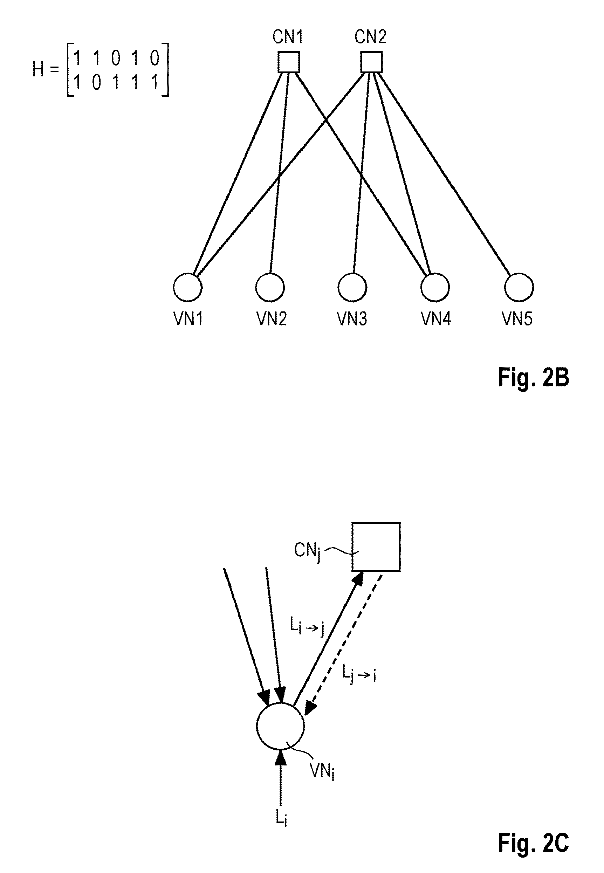

Figure 2B illustrates an exemplary parity-check matrix **H** of an LDPC code and the corresponding Tanner graph (for simplicity, the parity-check matrix **H** shown here is much smaller than the parity-check matrices of practically used LDPC codes). The parity-check matrix **H** has format $2 \times 5$. Hence, there are two check nodes CN1, CN2 and 5 variable nodes VN1, VN2, VN3, VN4, VN5.

In many cases LDPC codes are decoded by algorithms which are based on the Tanner graph. By way of example, message passing algorithms may be used. Message passing algorithms operate via passing messages along the edges of the Tanner graph. The term "message passing algorithm" shall be understood in this specification in a broad sense and include virtually all algorithms based on propagating messages through a graph representing the code (e.g. a Tanner graph), in particular belief propagation (BF) algorithms and sum-product algorithms.

Figure 2C represents a portion of a Tanner graph and illustrates decoding of an LDPC code by message passing. The variable node VNi is provided with an initial estimate $L_i$ of the likelihood that the output of the channel is 1. $L_i$ may be binary or, more often, is a soft output of the channel, e.g. an LLR (logarithm-likelihood ratio). At each iteration of the decoding, the variable node VNi broadcasts an extrinsic information $L_{i \to j}$ to the check nodes to which it is connected via an edge of the Tanner graph and receives an extrinsic information $L_{j \to i}$ from the check nodes to which it is connected via an edge of the Tanner graph.

This process is repeated. During these exchanges of extrinsic information, probabilities are calculated and recalculated locally both at the variable nodes and the check nodes. At the last step of the iteration, a final estimate is computed at each variable node. Then, a hard decision may be made on each bit by comparing the final estimate at each variable node with 0.5 in order to arrive at the estimated codeword.

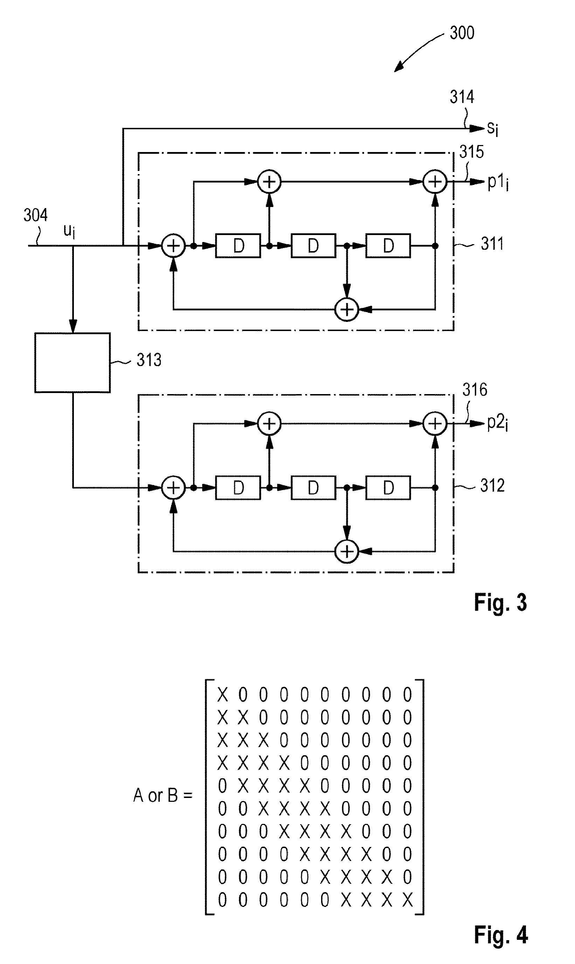

Figure 3 depicts a schematic of an exemplary turbo encoder 300. Such turbo encoder 300 may be used as the channel encoder 111 shown in Figure 1B. The turbo encoder 300 includes a first constituent (convolutional) encoder 311, a second constituent (convolutional) encoder 312 and a block interleaver 313. The input of the first constituent encoder 311 is connected to a turbo encoder input 304 (corresponding to input 104 of Figure 1B). The input of the second constituent encoder 312 is coupled via the block interleaver 313 to the turbo encoder input 304. The turbo encoder 300 may have three outputs 314, 315, 316. The output 314 provides the so-called systematic signal s. The output 315 from the first constituent encoder 311 is the first parity signal p1 and the output 316 from the second constituent encoder 312 is the second parity signal p2.

The input data sequence at input 304 is given by the information bits $u_i$. Systematic bits $s_i$ at output 314 are the unprocessed input information bits $u_i$. First parity bits at output 315 are denoted by $p1_i$ and second parity bits at output 316 are denoted by $p2_i$. Thus, output from the turbo encoder 300 is of the form $s_1, s_2, ..., s_k$, $p1_1, p1_2, ..., p1_k$, $p2_1, p2_2, ..., p2_k$, with the specific ordering of the bits defined by the final implementation.

As three output bits $s_i$, $p1_i$, $p2_i$ are generated for each input bit $u_i$, the code rate of the code generated by the turbo encoder 300 depicted in Figure 2 is 1/3.

Each constituent encoder 311, 312 may include a shift register with, e.g., three delay elements D, i.e. is a 8-state convolutional encoder. The underlying systematic recursive convolutional code of each constituent encoder 311, 312 is of code rate 1/2 and described by the transfer function

$$G(D) = \left[ 1, \frac{g_1(D)}{g_0(D)} \right],$$

where

$$g_0(D) = 1 + D^2 + D^3,$$

$$g_1(D) = 1 + D + D^3.$$

The constraint length L of the turbo code generated by a turbo encoder is the constraint length of the constituent convolutional code of the turbo code, i.e. the number of delay elements plus 1. Hence, L = 4 for this example.

The turbo encoder 300 as shown in Figure 3 is a mere example as stipulated in the LTE-Standard 3GPP TS 36.212 v10.0.0 section 5.1.3.2 (2011-01) and in the UMTS-Standard 3GPP TS 25.212 v7.1.0 (2006-06). However, it should be understood that embodiments described herein include turbo encoders of different design, transfer function and constraint length L, as well as the turbo codes generated by those turbo encoders. In particular, turbo encoders as stipulated in the LTE and the LTE-A standard are included. Further, also turbo encoder variants which, e.g., employ two systematic recursive rate 1/3 convolutional constituent encoders are possible. Such turbo encoders output 4 parity bit streams. Although the following description is directed to turbo encoders generating 2 parity bit streams, embodiments described herein are not confined to such specific implementations.

Further, a systematic convolutional encoder may be used as the channel encoder 111 shown in Figure 1B. In this case, two output bits, namely $s_i$ (systematic bit) and $p_i$ (non-systematic or parity bit), are generated for each input bit $u_i$, and the code rate of the code generated by the systematic convolutional encoder is 1/2.

According to various embodiments described herein, a convenient sparse parity-check matrix for a turbo code or a convolutional code in replacement of **H** of equation (4) is built. Let $a_1, a_2, ..., a_k$ and $b_1, b_2, ..., b_k$ be any solution of the equation

$$\sum_{i=1}^{k} a_i\, u_i = \sum_{j=1}^{k} b_j\, v_j \qquad\qquad (5)$$

for any feasibly i-th information bit $u_i$ and j-th non-systematic bit $v_j$ of the convolutional code, wherein $k \geq L$ and L is the constraint length of the convolutional code (or convolutional code component of the turbo code). Note that only sequences (datawords) of $u_i$ (input data) and sequences of $v_j$ (encoded non-systematic data) are considered which are allowed by the convolutional code (or convolutional code components of the turbo code). Thus, in case of a convolutional encoder, $v_j = p_j$, and in case of a turbo encoder, $v_j = p1_j$, or $v_j = p2_j$.

Based on a solution $a_1, a_2, ..., a_k$ and $b_1, b_2, ..., b_k$ of equation (5), a parity check matrix

$$H_T = \begin{bmatrix} A & B & 0 \\ AU^T & 0 & B \end{bmatrix} \qquad\qquad (6\text{a})$$

for turbo codes or

$$H_C = \begin{bmatrix} A & B \end{bmatrix} \qquad\qquad (6\text{b})$$

for systematic convolutional codes is built. Here, **U** is the permutation matrix of format $k \times k$ as used in the block interleaver 313 of the turbo encoder 300 and, e.g.,

$$A = \begin{bmatrix} a_{11} & a_{12} & \cdots & a_{1k} \\ a_{21} & a_{22} & & a_{2k} \\ & \vdots & \ddots & \vdots \\ a_{k1} & a_{n2} & \cdots & a_{kk} \end{bmatrix}$$

$$B = \begin{bmatrix} b_{11} & b_{12} & \cdots & b_{1k} \\ b_{21} & b_{22} & & b_{2k} \\ & \vdots & \ddots & \vdots \\ b_{k1} & b_{k2} & \cdots & b_{kk} \end{bmatrix}$$

$$\text{with } a_{ij} = \begin{cases} a_{j-i+L} & i - L + 1 \leq j \leq i \\ 0 & \text{otherwise} \end{cases} \quad \text{and}$$

$$b_{ij} = \begin{cases} b_{j-i+L} & i - L + 1 \leq j \leq i \\ 0 & \text{otherwise} \end{cases} \quad (7)$$

By definition of their elements, it can be observed that both matrices **A** and **B** are sparse and so are $H_T$ and $H_C$, when k is significantly larger than L. That is, the memory of the convolutional code (or convolutional code components of a turbo decoder) is much smaller than the size of the redundancy per convolutional (or convolutional component) coder.

The sparse nature of **A** and **B** is illustrated by way of example in Figure 4. It is to be noted that both matrices **A** and **B** may be lower triangular k × k matrices with only a diagonal stripe of L entries in column direction may be different from 0. In Figure 4, by way of example, L = 4 and k = 10 has been chosen for purpose of illustration. In practice, k and L are typically much greater than 10, while L << k. By way of example, k may be equal to or larger than 5, 10, 20, 50, 80 or 100 times L.

Based on one of these sparse matrices $H_T$ (for turbo codes) or $H_C$ (for convolutional codes), an LDPC decoder may be used for decoding. More specifically, an LDPC decoder using the message passing algorithm may be used. It is to be noted that the structure of the matrices **A** and **B** can be exploited to reduce the time complexity of the message passing algorithm from $O(k^2)$ to $O(k)$. That is, even though the decoding performance of the decoders and decoding methods described herein may be lower than that of a "specialized" turbo or convolutional decoder, $H_T$ and/or $H_C$ can lead to implementations which are rather simple and performant.

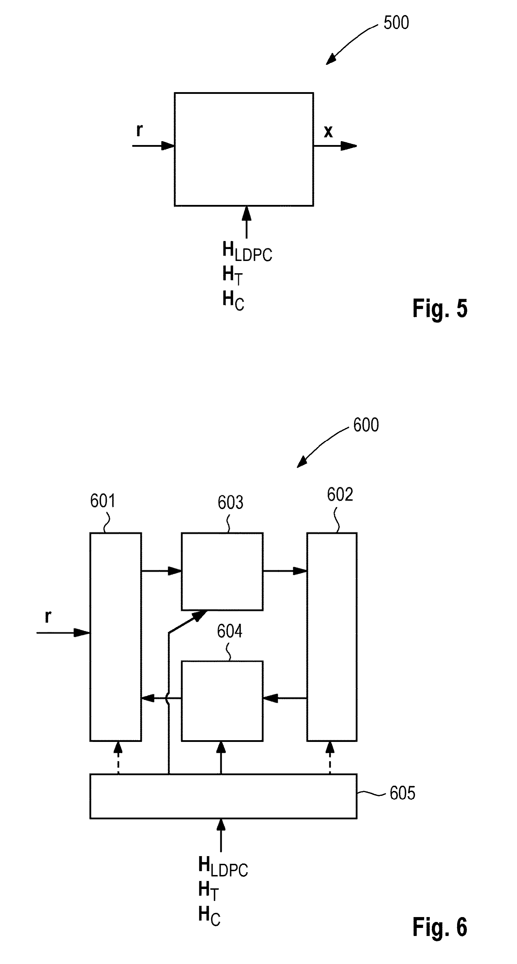

Figure 5 illustrates an LDPC decoder 500 in accordance with various embodiments described herein. The LDPC decoder 500 may correspond to decoder 122 of Figure 1B, i.e. is configured to decode a received vector **r** to yield the decoded word **x.** The LDPC decoder 500 may be used to decode first data encoded by an LDPC code by operating on an LDPC parity-check matrix $H_{LDPC}$. Further, the LDPC decoder 500 may be configured to decode second data encoded by a convolutional code or a turbo code. In this case the LDPC decoder 500 is operating on a sparse parity-check matrix $H_T$ or $H_C$ in accordance with equations (6a) and (6b), respectively.

It is to be noted that the performance of the message passing algorithm (e.g. the belief propagation (BF) technique) on LDPC decoders is highly dependent on the properties of the parity-check matrix, here $H_{LDPC}$, $H_T$ and/or $H_C$. The sparsity of the matrix, its girth, the number of short cycles and its regularity (i.e. the cycle structure of the Tanner graph that represents such matrix) play a critical role in the performance of the final message passing algorithm (or BF) based LDPC decoder. Since in general k >> L, $H_T$ and/or $H_C$ are L-sparse, which is beneficial in view of achievable decoder performance.

Decoder performance may be further improved by the following optimization approach. Equation (5) may have a plurality of solutions $(a_1,...,a_k;b_1,...,b_k)$. Let $X_Q$ be the set of solutions of equation (5), i.e. $X_Q = \{x_q \mid q = 1,...,Q\}$ with $x_q = (a_1,...,a_k;b_1,...,b_k)_q$ is the q-th solution and Q is the number of solutions of equation (5). Then, the matrices **A** and/or **B** may be improved or optimized over $X_Q$ (or a subset of $X_Q$) according to a matrix structure decoder performance criterion. That is, a better or best solution $x_{q\_b}$ could be determined which leads to improved or optimum matrices **A, B** in view of decoder performance. To that end, by way of example, each row of **A** and/or each row of **B** can be generated for a specific solution $x_q$ or a linear combination of the Q solutions (or a subset thereof) available.

More specifically, many kinds of matrix structure decoder performance criterions may be feasible. By way of example, the criterion may include a matrix-based approach in terms of high or maximum matrix sparsity, low or minimum matrix regularity, or other extremum matrix structure properties which are known to improve decoder performance. It may also include a variational approach to determine optimum matrices **A** and/or **B** by finding a best solution $x_{q\_b}$ or a best linear combination of solutions by variational computation to maximize (simulated) decoder output performance for a given decoder algorithm over $X_Q$ (or a subset of $X_Q$).

It is to be noted that the same decoder hardware may be used for decoding LDPC codes and convolutional codes or turbo codes. In all these cases decoding may be performed by using a message passing algorithm. When switching from one channel code to the other channel code (e.g. from an LDPC code to a convolutional code or a turbo code), the message passing algorithm is simply adapted by reprogramming the decoder to operate according to the Tanner graph representing the (sparse) parity-matrix of the newly elected code.

Further, it is to be noted that an existing LDPC decoder may be advanced to an LDPC decoder with the ability to decode turbo codes and/or convolutional codes by simply carrying out a firmware update. That is, no additional hardware may be needed to advance an existing LDPC decoder to a convolutional code decoder or a turbo decoder.

Using the LDPC decoder as a convolutional code decoder or turbo decoder neither necessitates changes nor even knowledge about decoder operation at the encoder side. Moreover, the LDPC convolutional code/turbo code decoder can be set to recover a given convolutional code or turbo code with fixed parameters by setting the correct parity-check matrix, regardless of the encoder used.

The ability of adding a turbo code or convolutional code decoding functionality to an LDPC decoder may be particularly beneficial in communication systems in which both code types are used. By way of example, WiMax uses LDPC codes and turbo codes.

Further, as LDPC codes are recently gaining more popularity, they may potentially replace today's turbo codes by standard evolution. In order to remain compatible with legacy equipment, this would require advanced mobile devices to include both an LDPC decoder and a turbo decoder. By way of example, the turbo decoder may only be needed to decode specific signals such as, e.g., emergency calls. In this case, the LDPC decoder 500 would operate in normal mode on the LDPC encoded received signals, while offering the ability to operate in an auxiliary mode (e.g. for decoding the specific signals) as a turbo decoder or a convolutional code decoder.

Figure 6 illustrates a more detailed block diagram of an exemplary LDPC decoder 600. The LDPC decoder 600 may be identical to LDPC decoder 500. The LDPC decoder 600 may include a variable node circuitry 601, a check node circuitry 602, and a message passing circuitry. The variable node circuitry 601 and the check node circuitry 602 are configured to exchange messages between one another in accordance with a parity-check matrix $\mathbf{H}_{LDPC}$, $\mathbf{H}_T$, or $\mathbf{H}_C$. Message exchange is performed and controlled by a message passing circuitry.

The message passing circuitry may include front shifters 603, back shifters 604 and a message passing scheduler 605. The variable node circuitry 601 is provided with the channel output vector $\mathbf{r}$, e.g. in the format of LLRs. The front shifters 603 are configured to transport messages from the variable nodes of the variable node circuitry 601 to the check nodes of the check node circuitry 602, and the back shifters 604 are configured to transport messages from the check nodes of the check node circuitry 602 to the variable nodes of the variable node circuitry 601.

The message passing scheduler 605 may be configured to schedule an order of passing messages between the variable nodes of the variable node circuitry 601 and the check nodes of the check node circuitry 602 along the edges of the Tanner graph representing $\mathbf{H}_{LDPC}$, $\mathbf{H}_T$, or $\mathbf{H}_C$. To that end, the message passing scheduler 605 is operatively coupled to the front shifters 603, the back shifters 604 and, optionally, to the variable nodes of the variable node circuitry 601 and/or the check nodes of the check node circuitry 602.

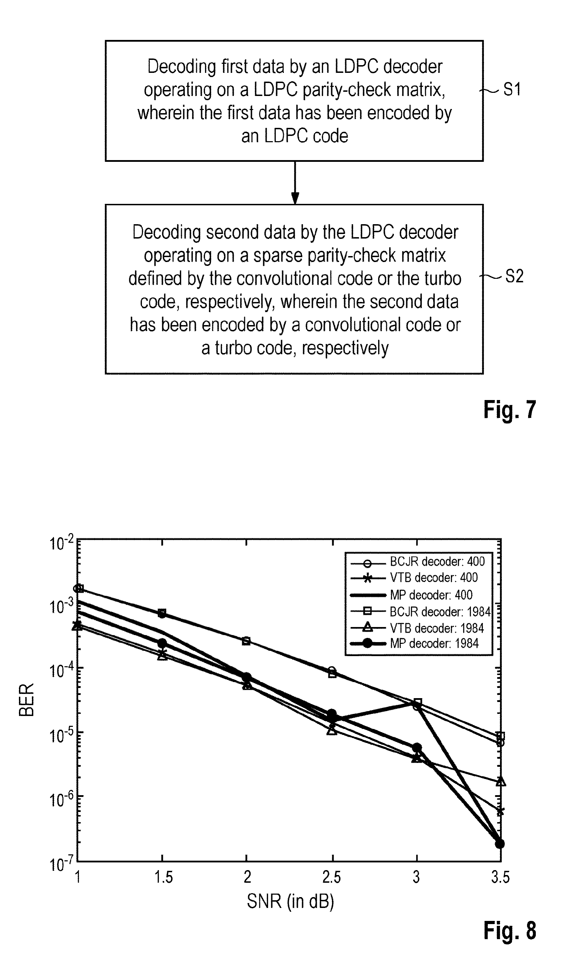

Figure 7 illustrates a process flow diagram for decoding first data encoded by an LDPC code and second data encoded by a convolutional code or a turbo code. At S1 first data is decoded by an LDPC decoder operating on a LDPC parity-check matrix. At S2 second data is decoded by the LDPC decoder operating on a sparse parity-check matrix defined by the convolutional code or the turbo code, respectively.

Figure 8 illustrates simulation results of decoding convolutional codes of source code block lengths 400 and 1984 with the BCJR algorithm, the Viterbi algorithm, and the message passing algorithm as described herein. The convolutional codes used for simulation are the component codes of the turbo code stipulated in the LTE-Standard 3GPP TS 36.212 v10.0.0 section 5.1.3.2.1 (2011-01), see Figure 3 and the transfer function G(D) stated above. The coding rate is 1/2. As shown, the message passing (MP) algorithm performs better in terms of BER than the BCJR algorithm and approximates the performance of the Viterbi (VT) algorithm both for source block lengths 400 and 1984.

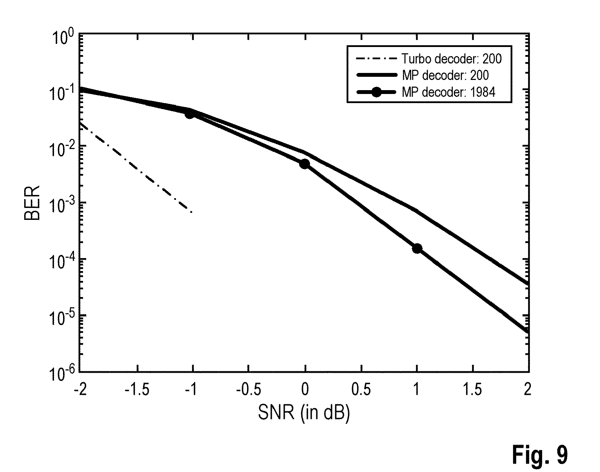

Figure 9 illustrates simulation results of decoding turbo codes of source code block lengths 200 and 1984 with a turbo decoder and the message passing (MP) algorithm described herein. The turbo codes used for simulation are stipulated in the LTE/-A-Standard 3GPP TS 36.212 v10.0.0 section 5.1.3.2 (2011-01). The coding rate is 1/3. As shown, the performance of the turbo decoder is better in terms of BER than the performance of the LDPC decoder using the message passing algorithm for turbo code decoding. Nevertheless, turbo code decoding by using the LDPC decoder is possible and may allow for substantial savings in hardware, chip area and/or decoding latencies.

EXAMPLES

The following examples pertain to further embodiments.

Example 1 is a method of decoding first data encoded by an LDPC code and second data encoded by a convolutional code or a turbo code, the method comprising: decoding first data by an LDPC decoder operating on a LDPC parity-check matrix; and decoding second data by the LDPC decoder operating on a sparse parity-check matrix defined by the convolutional code or the turbo code, respectively.

In Example 2, the subject matter of Example 1 can optionally include that decoding of first data and second data comprises decoding the first data and the second data with a message passing algorithm.

In Example 3, the subject matter of Example 1 or 2 can optionally include that the second data is encoded by a convolutional (n,k) code of codeword length n and dataword length k and the sparse parity-check matrix is of the form $H_C$ = **[A B],** with **A** and **B** being sparse k × k matrices.

In Example 4, the subject matter of Example 3 can optionally include that **A** and **B** are lower triangular k × k matrices.

In Example 5, the subject matter of Examples 1-4 can optionally include that **A** = ($a_{ij}$), with i = 1,...,k and j = 1,...,k, and $a_{ij} = a_{j-1+L}$ for i-L+1≤j≤i, otherwise $a_{ij}$ = 0, wherein **B** = ($b_{ij}$), with i = 1,...,k and j = 1,...,k, and $b_{ij} = b_{j-1+L}$ for i-L+1≤j≤i, otherwise $b_{ij}$ = 0, with L being the constraint length of the convolutional code, with $a_1,...,a_k$ and $b_1,...,b_k$ is any solution of the equation wherein $\sum_{i=1}^{k} a_i\, u_i = \sum_{j=1}^{k} b_j\, v_j$ for any feasibly i-th information bit $u_i$ and j-th non-systematic bit $v_j$ of the convolutional code.

In Example 6, the subject matter of Examples 1-5 can optionally include wherein the constraint length L is much smaller than k.

In Example 7, the subject matter of Examples 1-6 can optionally include that at least one of A and B is formed by applying a matrix structure decoder performance criterion over a plurality of solutions $a_1,...,a_k$ and $b_1,...,b_k$.

In Example 8, the subject matter of Example 1 or 2 can optionally include that the second data is encoded by a turbo (n,k) code of convolutional component codeword length n and dataword length k and the sparse parity-check matrix is of the form $H_T = \begin{bmatrix} A & B & 0 \\ AU^T & 0 & B \end{bmatrix}$, with **A** and **B** being sparse k × k matrices, **0** being a zero k × k matrix, and **U**$^T$ being a transpose of a turbo code interleaver permutation matrix **U** of format k × k.

In Example 9, the subject matter of Example 8 can optionally include that **A** and **B** are lower triangular k × k matrices.

In Example 10, the subject matter of Example 8 or 9 can optionally include that **A** = ($a_{ij}$), with i = 1,...,k and j = 1,...,k, and $a_{ij} = a_{j-1+L}$ for i-L+1≤j≤i, otherwise $a_{ij}$ = 0, wherein **B** = ($b_{ij}$), with i = 1,...,k and j = 1,...,k, and $b_{ij} = b_{j-1+L}$ for i-L+1≤j≤i, otherwise $b_{ij}$ = 0, with L being the constraint length of a constituent convolutional code of the turbo code, with $a_1,...,a_k$ and $b_1,...,b_k$ being any solution of the equation $\sum_{i=1}^{k} a_i\, u_i = \sum_{j=1}^{k} b_j\, v_j$ for any feasibly i-th information bit $u_i$ and j-th non-systematic bit $v_j$ of the turbo code.

In Example 11, the subject matter of Example 10 can optionally include wherein the constraint length L is much smaller than k.

In Example 12, the subject matter of Example 10 or 11 can optionally include that at least one of **A** and **B** is formed by applying a matrix structure decoder performance criterion over a plurality of solutions $a_1,...,a_k$ and $b_1,...,b_k$.

In Example 13, the subject matter of Example 1 or 2 can optionally include wherein the sparse parity-check matrix is of maximum sparsity among all parity-check matrices of the convolutional code or the turbo code, and/or wherein the sparse parity-check matrix is of minimum regularity among all parity-check matrices of the convolutional code or the turbo code.

Example 14 is a method of decoding data encoded by a convolutional code or a turbo code, the method comprising: decoding the data by using an LDPC decoder operating on a sparse parity-check matrix defined by the convolutional code or the turbo code, respectively.

In Example 15, the subject matter of Example 14 can optionally include wherein decoding the data with a message passing algorithm.

In Example 16, the subject matter of Example 15 can optionally include wherein decoding the data with a belief propagation (BF) algorithm.

In Example 17, the subject matter of Example 15 can optionally include wherein decoding the data with a sum-product algorithm.

Example 18 is decoder for decoding first data encoded by an LDPC code and second data encoded by a convolutional code or a turbo code, the decoder comprising: a variable node circuitry; a check node circuitry; and a message passing circuitry, wherein the variable node circuitry and the check node circuitry are configured to exchange messages with one another based on a sparse parity-check matrix that represents the LDPC code for decoding the first data and the convolutional code or the turbo code for decoding the second data.

In Example 19, the subject matter of Example 18 can optionally include that the message passing circuitry comprises front shifters configured to pass the messages from variable nodes of the variable node circuitry to check nodes of the check node circuitry.

In Example 20, the subject matter of Examples 18 or 19 can optionally include that the message passing circuitry comprises back shifters configured to pass the messages from check nodes of the check node circuitry to variable nodes of the variable node circuitry.

In Example 21, the subject matter of Examples 18-20 can optionally include that the message passing circuitry comprises: a message passing scheduler configured to schedule an order of passing the messages between variable nodes of the variable node circuitry and check nodes of the check node circuitry.

In Example 22, the subject matter of Examples 18-21 can optionally include that the decoder is configured to decode second data encoded by a turbo code as stipulated in the LTE-Standard 3GPP TS 36.212 v10.0.0 section 5.1.3.2 (2011-01).

In Example 23, the subject matter of Examples 18-21 can optionally include that the decoder is configured to decode second data encoded by a convolutional code as stipulated in the LTE-Standard 3GPP TS 36.212 v10.0.0 section 5.1.3.2.1 (2011-01).

In Example 24, the subject matter of Examples 18-23 can optionally include that the decoder is configured to decode second data encoded by a convolutional code based on a parity-check matrix which is of maximum sparsity among all parity-check matrices of the convolutional code.

In Example 25, the subject matter of Examples 18-23 can optionally include that the decoder is configured to decode second data encoded by a convolutional code based on a parity-check matrix which is of minimum regularity among all parity-check matrices of the convolutional code.

In Example 26, the subject matter of Examples 18-23 can optionally include that the decoder is configured to decode second data encoded by a turbo code based on a parity-check matrix which is of maximum sparsity among all parity-check matrices of the turbo code.

In Example 27, the subject matter of Examples 18-23 can optionally include that the decoder is configured to decode second data encoded by a turbo code based on a parity-check matrix which is of minimum regularity among all parity-check matrices of the turbo code.

Example 28 is decoder for decoding a convolutional code or a turbo code, the decoder comprising: a variable node circuitry; a check node circuitry; and a message passing circuitry, wherein the variable node circuitry and the check node circuitry are configured to exchange messages with one another based on a sparse parity-check matrix that represents the convolutional code or the turbo code.

In Example 29, the subject matter of Example 28 can optionally include that the message passing circuitry comprises front shifters configured to pass the messages from variable nodes of the variable node circuitry to check nodes of the check node circuitry.

In Example 30, the subject matter of Examples 28 or 26 can optionally include that the message passing circuitry comprises back shifters configured to pass the messages from check nodes of the check node circuitry to variable nodes of the variable node circuitry.

In Example 31, the subject matter of Examples 28-30 can optionally include that the message passing circuitry comprises: a message passing scheduler configured to schedule an order of passing the messages between variable nodes of the variable node circuitry and check nodes of the check node circuitry.

In Example 32, the subject matter of Examples 28-31 can optionally include that the decoder is configured to decode a convolutional (n,k) code of codeword length n and dataword length k and the sparse parity-check matrix is of the form $H_C = $ **[A B],** with **A** and **B** being sparse k $\times$ k matrices.

In Example 33, the subject matter of Example 32 can optionally include that **A** and **B** are lower triangular k $\times$ k matrices.

In Example 33, the subject matter of Examples 28-31 can optionally include that the decoder is configured to decode a turbo (n,k) code of convolutional component codeword length n and dataword length k and the sparse parity-check matrix is of the form $H_T = \begin{bmatrix} A & B & 0 \\ AU^T & 0 & B \end{bmatrix}$, with **A** and **B** being sparse k $\times$ k matrices, **0** being a zero k $\times$ k

matrix, and **U**$^T$ being a transpose of a turbo code interleaver permutation matrix **U** of format k $\times$ k.

In Example 35, the subject matter of Example 34 can optionally include that **A** and **B** are lower triangular k $\times$ k matrices.

In addition, while a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it is understood that aspects of the disclosure may be implemented in discrete circuits, partially integrated circuits or fully integrated circuits or programming means. Also, the terms "exemplary", "for example" and "e.g." are merely meant as an example, rather than the best or optimal.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

### Claims

1. A method of decoding first data encoded by a low density parity-check (LDPC) code and second data encoded by a convolutional code or a turbo code, the method comprising:

   decoding first data by an LDPC decoder operating on a LDPC parity-check matrix; and
   decoding second data by the LDPC decoder operating on a sparse parity-check matrix defined by the convolutional code or the turbo code, respectively.

2. The method of claim 1, wherein decoding first data and second data comprises decoding the first data and second data with a message passing algorithm.

3. The method of claim 1 or 2, wherein the second data is encoded by a convolutional (n,k) code of codeword length n and dataword length k and the sparse parity-check matrix is of the form $H_C = $ **[A B],** with **A** and **B** being sparse k $\times$ k matrices.

4. The method of claim 3, wherein $\mathbf{A} = (a_{ij})$, with $i = 1,...,k$ and $j = 1,...,k$, and $a_{ij} = a_{j-1+L}$ for $i-L+1 \leq j \leq i$, otherwise $a_{ij} = 0$, wherein $\mathbf{B} = (b_{ij})$, with $i = 1,...,k$ and $j = 1,...,k$, and $b_{ij} = b_{j-1+L}$ for $i-L+1 \leq j \leq i$, otherwise $b_{ij} = 0$, with L being the constraint length of the convolutional code, with $a_1,...,a_k$ and $b_1,...,b_k$ being any solution of the equation wherein

$$\sum_{i=1}^{k} a_i\, u_i = \sum_{j=1}^{k} b_j\, v_j$$ for any feasibly i-th information bit $u_i$ and j-th non-systematic bit $v_j$ of the convolutional code.

5. The method of claim 4, wherein the constraint length L is much smaller than k.

6. The method of claim 4 or 5, wherein at least one of $\mathbf{A}$ and $\mathbf{B}$ is formed by applying a matrix structure decoder performance criterion over a plurality of solutions $a_1,...,a_k$ and $b_1,...,b_k$.

7. The method of claim 1 or 2, wherein the second data is encoded by a turbo (n,k) code of convolutional component codeword length n and dataword length k and the sparse parity-check matrix is of the form

$$H_T = \begin{bmatrix} A & B & 0 \\ AU^T & 0 & B \end{bmatrix},$$ with $\mathbf{A}$ and $\mathbf{B}$ being sparse $k \times k$ matrices, $\mathbf{0}$ being a zero $k \times k$ matrix, and $\mathbf{U}^T$ being a transpose of a turbo code interleaver permutation matrix $\mathbf{U}$ of format $k \times k$.

8. The method of claim 7, wherein $\mathbf{A} = (a_{ij})$, with $i = 1,...,k$ and $j = 1,...,k$, and $a_{ij} = a_{j-1+L}$ for $i-L+1 \leq j \leq i$, otherwise $a_{ij} = 0$, wherein $\mathbf{B} = (b_{ij})$, with $i = 1,...,k$ and $j = 1,...,k$, and $b_{ij} = b_{j-1+L}$ for $i-L+1 \leq j \leq i$, otherwise $b_{ij} = 0$, with L being the constraint length of a constituent convolutional code of the turbo code, with $a_1,...,a_k$ and $b_1,...,b_k$ being any solution of the equation $$\sum_{i=1}^{k} a_i\, u_i = \sum_{j=1}^{k} b_j\, v_j$$ for any feasibly i-th information bit $u_i$ and j-th non-systematic bit $v_j$ of the turbo code.

9. The method of claim 8, wherein the constraint length L is much smaller than k.

10. The method of claim 8 or 9, wherein at least one of $\mathbf{A}$ and $\mathbf{B}$ is formed by applying a matrix structure decoder performance criterion over a plurality of solutions $a_1,...,a_k$ and $b_1,...,b_k$.

11. The method of one of the preceding claims, wherein the sparse parity-check matrix is of maximum sparsity among all parity-check matrices of the convolutional code or the turbo code, and/or wherein the sparse parity-check matrix is of minimum regularity among all parity-check matrices of the convolutional code or the turbo code.

12. A decoder for decoding first data encoded by a low density parity-check (LDPC) code and second data encoded by a convolutional code or a turbo code, the decoder comprising:

   a variable node circuitry;
   a check node circuitry; and
   a message passing circuitry, wherein the variable node circuitry and the check node circuitry are configured to exchange messages with one another based on a sparse parity-check matrix that represents the LDPC code for decoding the first data and the convolutional code or the turbo code for decoding the second data.

13. The decoder of claim 12, wherein the message passing circuitry comprises:

   front shifters configured to pass the messages from variable nodes of the variable node circuitry to check nodes of the check node circuitry.

14. The decoder of claim 12 or 13, wherein the message passing circuitry comprises:

   back shifters configured to pass the messages from check nodes of the check node circuitry to variable nodes of the variable node circuitry.

15. The decoder of one of claims 12 to 14, wherein the message passing circuitry comprises:

   a message passing scheduler configured to schedule an order of passing the messages between variable nodes of the variable node circuitry and check nodes of the check node circuitry.

base station or
network node

101

UL

104

100

103

DL

102

mobile device

**Fig. 1A**

Fig. 1B

Fig. 2A

$$H = \begin{bmatrix} 1 & 1 & 0 & 1 & 0 \\ 1 & 0 & 1 & 1 & 1 \end{bmatrix}$$

CN1   CN2

VN1   VN2   VN3   VN4   VN5

**Fig. 2B**

CNj

$L_{i \to j}$

$L_{j \to i}$

VNi

$L_i$

**Fig. 2C**

**Fig. 3**

**Fig. 4**

**Fig. 5**

**Fig. 6**

```
┌─────────────────────────────────────────┐
│ Decoding first data by an LDPC decoder    │
│ operating on a LDPC parity-check matrix,  │  ~ S1
│ wherein the first data has been encoded by│
│ an LDPC code                              │
└─────────────────────────────────────────┘
                    │
                    ▼
┌─────────────────────────────────────────┐
│ Decoding second data by the LDPC decoder  │
│ operating on a sparse parity-check matrix │
│ defined by the convolutional code or the turbo │  ~ S2
│ code, respectively, wherein the second data │
│ has been encoded by a convolutional code or │
│ a turbo code, respectively                │
└─────────────────────────────────────────┘
```

**Fig. 7**

**Fig. 8**

Fig. 9

Europäisches
Patentamt

European
Patent Office

Office européen
des brevets

**EUROPEAN SEARCH REPORT**

Application Number

EP 16 19 1471

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 962 430 A1 (SAMSUNG ELECTRONICS UK LTD [GB]; CENTRE NAT RECH SCIENT [FR]) 27 August 2008 (2008-08-27) * the whole document * ----- | 1-15 | INV. H03M13/11 H03M13/23 H03M13/29 |
| X | YING CUI ET AL: "Design of turbo codes without 4-cycles in Tanner graph representation for message passing algorithm", PROC., IEEE 7TH INTERNATIONAL COLLOQUIUM ON SIGNAL PROCESSING AND ITS APPLICATIONS, CSPA 2011, 4 March 2011 (2011-03-04), pages 108-111, XP031863266, DOI: 10.1109/CSPA.2011.5759853 ISBN: 978-1-61284-414-5 * the whole document * ----- | 1-15 | |
| X | AHMED REFAEY ET AL: "On the application of BP decoding to convolutional and turbo codes", PROC., IEEE 43RD ASILOMAR CONFERENCE ON SIGNALS, SYSTEMS AND COMPUTERS, 2009, 1 November 2009 (2009-11-01), pages 996-1001, XP031679565, ISBN: 978-1-4244-5825-7 | 1-10, 12-15 | |
| A | * the whole document * ----- | 11 | TECHNICAL FIELDS SEARCHED (IPC) H03M |

-/--

The present search report has been drawn up for all claims

| Place of search | Date of completion of the search | Examiner |
|---|---|---|
| Munich | 23 March 2017 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 16 19 1471

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LIANXIANG ZHU ET AL: "Iterative decoding of Turbo codes based on factor graphs", PROC., IEEE REGION 10 CONFERENCE ON COMPUTERS, COMMUNICATIONS, CONTROL AND POWER ENGINEERIN, BEIJING, CHINA, vol. 2, 28 October 2002 (2002-10-28), - 31 October 2002 (2002-10-31), pages 1077-1081, XP010627431, DOI: 10.1109/TENCON.2002.1180310 ISBN: 978-0-7803-7490-4 | 1-5, 12-15 | |
| A | * the whole document * | 6-11 | |
| A | MACKAY D J C: "Good error-correcting codes based on very sparse matrices", IEEE TRANSACTIONS ON INFORMATION THEORY, IEEE PRESS, USA, vol. 45, no. 2, 1 March 1999 (1999-03-01), pages 399-431, XP002143042, ISSN: 0018-9448, DOI: 10.1109/18.748992 * page 421; figure 21 * | 1-15 | |

TECHNICAL FIELDS
SEARCHED      (IPC)

The present search report has been drawn up for all claims

| Place of search | Date of completion of the search | Examiner |
|---|---|---|
| Munich | 23 March 2017 | Offer, Elke |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 3 301 814 A1**

## ANNEX TO THE EUROPEAN SEARCH REPORT
## ON EUROPEAN PATENT APPLICATION NO.

EP 16 19 1471

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2017

| Patent document cited in search report | | Publication date | Patent family member(s) | | Publication date |
|---|---|---|---|---|---|
| EP 1962430 | A1 | 27-08-2008 | EP | 1962430 A1 | 27-08-2008 |
| | | | KR | 20080078596 A | 27-08-2008 |

EPO FORM P0459